# EUROPEAN PATENT APPLICATION

(11) **EP 4 246 232 A1**
(43) Date of publication of application: **20.09.2023**
(21) Application number: 22163108.8
(22) Date of filing: 18.03.2022
(51) Int. Cl.: G03F 9/00, G02B 5/18, G02B 27/00, G03H 1/04, G03F 7/20

(54) **ILLUMINATION ARRANGEMENT FOR A METROLOGY DEVICE AND ASSOCIATED METHOD**

(71) Applicant: Stichting VU, 1081 HV Amsterdam (NL); Stichting Nederlandse Wetenschappelijk Onderzoek Instituten, 3526 KV Utrecht (NL); Universiteit van Amsterdam, 1012 WX Amsterdam (NL); ASML Netherlands B.V., 5500 AH Veldhoven (NL)
(72) Inventor: VAN SCHAIJK, Theodorus, Thomas, Marinus, 5500 AH Veldhoven (NL); DEN BOEF, Arie, Jeffrey, 5500 AH Veldhoven (NL); DE BOER, Johannes, Fitzgerald, 1081 HV Amsterdam (NL); MESSINIS, Christos, 1081 HV Amsterdam (NL); BUIJS, Robin, Daniel, 5500 AH Veldhoven (NL)
(74) Representative: ASML Netherlands B.V.

(57) **Abstract**

Disclosed is an illumination arrangement for providing at least one radiation beam for use as an illumination beam and/or reference beam in a metrology device. The illumination arrangement comprises at least one radiation beam modifier module operable to receive source illumination and output a modified radiation beam comprising a first beam component and a second beam component. Each radiation beam modifier module comprises at least one path length varying arrangement for controllably varying the optical path length of at least one of said first beam component and said second beam component, such that said first beam component and second beam component of said modified radiation beam comprise a respective different optical path length.

## Description

### FIELD

The present invention relates to a metrology method and device which may, for example, be used for determining a characteristic of structures on a substrate.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

During the manufacturing process there is a need to inspect the manufactured structures and/or to measure characteristics of the manufactured structures. Suitable inspection and metrology apparatuses are known in the art. One of the known metrology apparatuses is a scatterometer and, for example, a dark field scatterometer.

Patent application publication US2016/0161864A1, patent application publication US2010/0328655A1 and patent application publication US2006/0066855A1 discuss embodiments of a photolithographic apparatus and, in particular, embodiments of a dark field scatterometer. WO2021/121733A1 discusses embodiments of a dark field holographic microscope (DHM). A DHM will allow the use of a simple objective lens, which allows a significant size and weight reduction of the sensor optics compared to a dark field scatterometer. This makes it easier to move the sensor over the wafer, while simultaneously enabling the use of multiple sensors on a single wafer. The cited documents are herein incorporated by reference.

In each of these types of metrology device, there will only be interference between light diffracted from the bottom and top gratings (or periodic structures) of an overlay target if the gratings are separated by not more than the coherence length of the light. While this is the case for many overlay targets, overlay targets for measurement of thick stacks may have a larger separation between gratings. While it is possible to use radiation with longer coherence lengths, a short coherence length is desirable to minimise nuisance sources.

It is desirable to improve methods of measuring such thick stacks.

### SUMMARY

In a first aspect of the invention, there is provided an illumination arrangement for providing at least one radiation beam for use as an illumination beam and/or reference beam in a metrology device, the illumination arrangement comprising: at least one radiation beam modifier module operable to receive source illumination and output a modified radiation beam comprising a first beam component and a second beam component, each said at least one radiation beam modifier module comprising: at least one path length varying arrangement for controllably varying the optical path length of at least one of said first beam component and said second beam component, such that said first beam component and second beam component of said modified radiation beam comprise a respective different optical path length.

In a second aspect of the invention, there is provided a method for providing at least one illumination beam or reference beam for a metrology device, the method comprising: receiving source illumination and generating a modified radiation beam comprising a first beam component and a second beam component; and controllably varying the optical path length of at least one of said first beam component and said second beam component, such that said first beam component and second beam component of said modified radiation beam comprise a respective different optical path length.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a schematic overview of a scatterometry apparatus used as a metrology device, which may comprise a dark field digital holographic microscope according to embodiments of the invention;
- Figure 5 depicts a schematic overview of a level sensor apparatus which may comprise a dark field digital holographic microscope according to embodiments of the invention;
- Figure 6 depicts a schematic overview of an alignment sensor apparatus which may comprise a dark field digital holographic microscope according to embodiments of the invention;
- Figure 7 depicts schematically an example of a diffraction-based dark field metrology device operated in a parallel acquisition scheme;
- Figure 8 depicts schematically a different example of a diffraction-based dark field metrology device operated in a sequential acquisition scheme;
- Figure 9 depicts schematically an example of a dark field digital holographic microscope operated in a sequential acquisition scheme;
- Figure 10 depicts schematically a dark field digital holographic microscope (df-DHM) operated in a parallel acquisition scheme, in accordance with an embodiment;
- Figures 11(a), 11(b), 11(c) and 11(b) comprises (a) a schematic diagram of a dark field scatterometer for use in measuring targets according to embodiments of the invention using a first pair of illumination apertures, (b) a detail of diffraction spectrum of a target grating for a given direction of illumination and (c) and (d) specific examples of aperture plates;
- Figure 12 depicts schematically an illumination arrangement according to an embodiment; and
- Figure 13 depicts a block diagram of a computer system for controlling a dark field digital holographic microscope.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

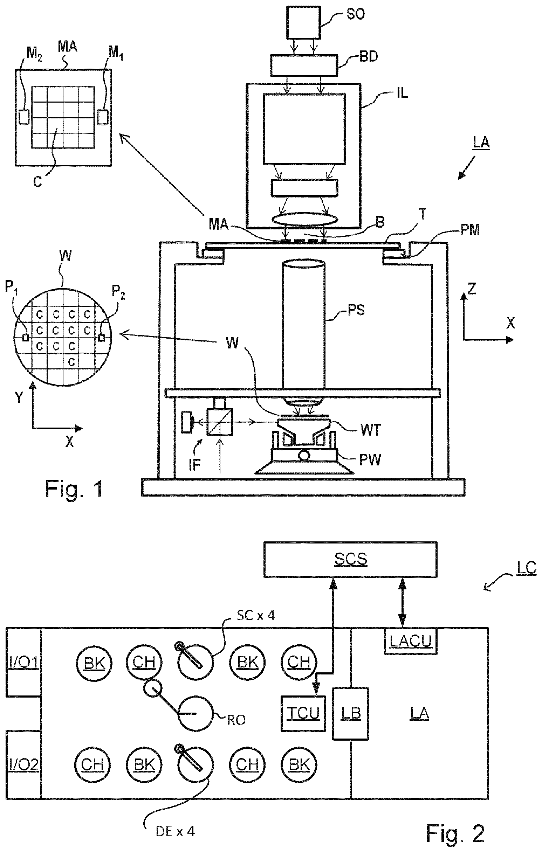

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks P1, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

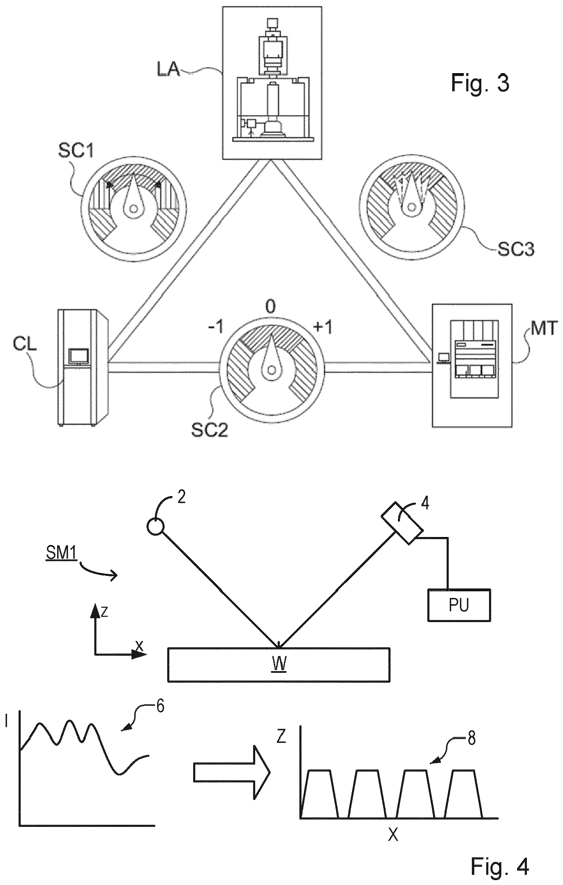

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is a ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

A metrology apparatus, such as a scatterometer, is depicted in Figure 4. It comprises a broadband (white light) radiation projector 2 which projects radiation onto a substrate W (optionally having been spectrally filtered to be narrowband prior to the substrate W) . The reflected or scattered radiation is passed to a spectrometer detector 4, which measures a spectrum 6 (i.e. a measurement of intensity as a function of wavelength) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 3. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

Overall measurement quality of a lithographic parameter via measurement of a metrology target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

Another type of metrology tool used in IC manufacture is a topography measurement system, level sensor or height sensor. Such a tool may be integrated in the lithographic apparatus, for measuring a topography of a top surface of a substrate (or wafer). A map of the topography of the substrate, also referred to as height map, may be generated from these measurements indicating a height of the substrate as a function of the position on the substrate. This height map may subsequently be used to correct the position of the substrate during transfer of the pattern on the substrate, in order to provide an aerial image of the patterning device in a properly focus position on the substrate. It will be understood that "height" in this context refers to a dimension broadly out of the plane to the substrate (also referred to as Z-axis). Typically, the level or height sensor performs measurements at a fixed location (relative to its own optical system) and a relative movement between the substrate and the optical system of the level or height sensor results in height measurements at locations across the substrate.

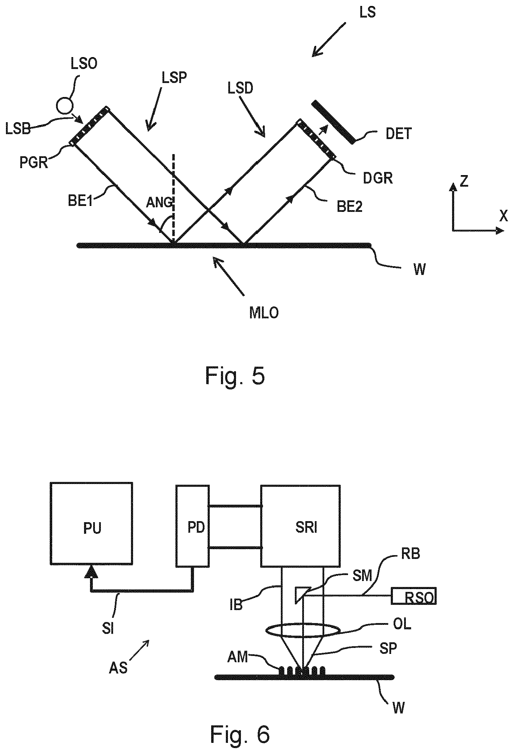

An example of a level or height sensor LS as known in the art is schematically shown in Figure 5, which illustrates only the principles of operation. In this example, the level sensor comprises an optical system, which includes a projection unit LSP and a detection unit LSD. The projection unit LSP comprises a radiation source LSO providing a beam of radiation LSB which is imparted by a projection grating PGR of the projection unit LSP. The radiation source LSO may be, for example, a narrowband or broadband light source, such as a supercontinuum light source, polarized or non-polarized, pulsed or continuous, such as a polarized or non-polarized laser beam. The radiation source LSO may include a plurality of radiation sources having different colors, or wavelength ranges, such as a plurality of LEDs. The radiation source LSO of the level sensor LS is not restricted to visible radiation, but may additionally or alternatively encompass UV and/or IR radiation and any range of wavelengths suitable to reflect from a surface of a substrate.

The projection grating PGR is a periodic grating comprising a periodic structure resulting in a beam of radiation BE1 having a periodically varying intensity. The beam of radiation BE1 with the periodically varying intensity is directed towards a measurement location MLO on a substrate W having an angle of incidence ANG with respect to an axis perpendicular (Z-axis) to the incident substrate surface between 0 degrees and 90 degrees, typically between 70 degrees and 80 degrees. At the measurement location MLO, the patterned beam of radiation BE1 is reflected by the substrate W (indicated by arrows BE2) and directed towards the detection unit LSD.

In order to determine the height level at the measurement location MLO, the level sensor further comprises a detection system comprising a detection grating DGR, a detector DET and a processing unit (not shown) for processing an output signal of the detector DET. The detection grating DGR may be identical to the projection grating PGR. The detector DET produces a detector output signal indicative of the light received, for example indicative of the intensity of the light received, such as a photodetector, or representative of a spatial distribution of the intensity received, such as a camera. The detector DET may comprise any combination of one or more detector types.

By means of triangulation techniques, the height level at the measurement location MLO can be determined. The detected height level is typically related to the signal strength as measured by the detector DET, the signal strength having a periodicity that depends, amongst others, on the design of the projection grating PGR and the (oblique) angle of incidence ANG.

The projection unit LSP and/or the detection unit LSD may include further optical elements, such as lenses and/or mirrors, along the path of the patterned beam of radiation between the projection grating PGR and the detection grating DGR (not shown).

In an embodiment, the detection grating DGR may be omitted, and the detector DET may be placed at the position where the detection grating DGR is located. Such a configuration provides a more direct detection of the image of the projection grating PGR.

In order to cover the surface of the substrate W effectively, a level sensor LS may be configured to project an array of measurement beams BE1 onto the surface of the substrate W, thereby generating an array of measurement areas MLO or spots covering a larger measurement range.

Various height sensors of a general type are disclosed for example in US7265364 and US7646471, both incorporated by reference. A height sensor using UV radiation instead of visible or infrared radiation is disclosed in US2010233600A1, incorporated by reference. In WO2016102127A1, incorporated by reference, a compact height sensor is described which uses a multi-element detector to detect and recognize the position of a grating image, without needing a detection grating.

Another type of metrology tool used in IC manufacture is an alignment sensor. A critical aspect of performance of the lithographic apparatus is therefore the ability to place the applied pattern correctly and accurately in relation to features laid down in previous layers (by the same apparatus or a different lithographic apparatus). For this purpose, the substrate is provided with one or more sets of marks or targets. Each mark is a structure whose position can be measured at a later time using a position sensor, typically an optical position sensor. The position sensor may be referred to as "alignment sensor" and marks may be referred to as "alignment marks".

A lithographic apparatus may include one or more (e.g. a plurality of) alignment sensors by which positions of alignment marks provided on a substrate can be measured accurately. Alignment (or position) sensors may use optical phenomena such as diffraction and interference to obtain position information from alignment marks formed on the substrate. An example of an alignment sensor used in current lithographic apparatus is based on a self-referencing interferometer as described in US6961116. Various enhancements and modifications of the position sensor have been developed, for example as disclosed in US2015261097A1. The contents of all of these publications are incorporated herein by reference.

Figure 6 is a schematic block diagram of an embodiment of a known alignment sensor AS, such as is described, for example, in US6961116, and which is incorporated by reference. Radiation source RSO provides a beam RB of radiation of one or more wavelengths, which is diverted by diverting optics onto a mark, such as mark AM located on substrate W, as an illumination spot SP. In this example the diverting optics comprises a spot mirror SM and an objective lens OL. The illumination spot SP, by which the mark AM is illuminated, may be slightly smaller in diameter than the width of the mark itself.

Radiation diffracted by the alignment mark AM is collimated (in this example via the objective lens OL) into an information-carrying beam IB. The term "diffracted" is intended to include zero-order diffraction from the mark (which may be referred to as reflection). A self-referencing interferometer SRI, e.g. of the type disclosed in US6961116 mentioned above, interferes the beam IB with itself after which the beam is received by a photodetector PD. Additional optics (not shown) may be included to provide separate beams in case more than one wavelength is created by the radiation source RSO. The photodetector may be a single element, or it may comprise a number of pixels, if desired. The photodetector may comprise a sensor array.

The diverting optics, which in this example comprises the spot mirror SM, may also serve to block zero order radiation reflected from the mark, so that the information-carrying beam IB comprises only higher order diffracted radiation from the mark AM (this is not essential to the measurement, but improves signal to noise ratios).

Intensity signals SI are supplied to a processing unit PU. By a combination of optical processing in the block SRI and computational processing in the unit PU, values for X- and Y-position on the substrate relative to a reference frame are output.

A single measurement of the type illustrated only fixes the position of the mark within a certain range corresponding to one pitch of the mark. Coarser measurement techniques are used in conjunction with this to identify which period of a sine wave is the one containing the marked position. The same process at coarser and/or finer levels may be repeated at different wavelengths for increased accuracy and/or for robust detection of the mark irrespective of the materials from which the mark is made, and materials on and/or below which the mark is provided. The wavelengths may be multiplexed and de-multiplexed optically so as to be processed simultaneously, and/or they may be multiplexed by time division or frequency division.

In this example, the alignment sensor and spot SP remain stationary, while it is the substrate W that moves. The alignment sensor can thus be mounted rigidly and accurately to a reference frame, while effectively scanning the mark AM in a direction opposite to the direction of movement of substrate W. The substrate W is controlled in this movement by its mounting on a substrate support and a substrate positioning system controlling the movement of the substrate support. A substrate support position sensor (e.g. an interferometer) measures the position of the substrate support (not shown). In an embodiment, one or more (alignment) marks are provided on the substrate support. A measurement of the position of the marks provided on the substrate support allows the position of the substrate support as determined by the position sensor to be calibrated (e.g. relative to a frame to which the alignment system is connected). A measurement of the position of the alignment marks provided on the substrate allows the position of the substrate relative to the substrate support to be determined.

In order to monitor the lithographic process, parameters of the patterned substrate are measured. Parameters may include, for example, the overlay error between successive layers formed in or on the patterned substrate. This measurement may be performed on a product substrate and/or on a dedicated metrology target. There are various techniques for making measurements of the microscopic structures formed in lithographic processes, including the use of scanning electron microscopes and various specialized tools. A fast and non-invasive form of specialized inspection tool is a scatterometer in which a beam of radiation is directed onto a target on the surface of the substrate and properties of the scattered or reflected beam are measured.

Examples of known scatterometers include angle-resolved scatterometers of the type described in US2006033921A1 and US2010201963A1. The targets used by such scatterometers are relatively large, e.g., 40µm by 40µm, gratings and the measurement beam generates a spot that is smaller than the grating (i.e., the grating is underfilled). In addition to measurement of feature shapes by reconstruction, diffraction based overlay can be measured using such apparatus, as described in published patent application US2006066855A1. Diffraction-based overlay metrology using dark field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

Dark field microscopes, such as the metrology device mentioned above and more generally, have the problem of having a limited range of angles for illumination of the target and/or detection of the light that is diffracted by the target, as it may be required that the total range of angles (corresponding to regions within the angle resolved pupil) are shared between the illumination path and detection path. This limits the effective NA in illumination and detection.

In a diffraction-based dark field metrology device, a beam of radiation is directed onto a metrology target and one or more properties of the scattered radiation are measured so as to determine a property of interest of the target. The properties of the scattered radiation may comprise, for example, intensity at a single scattering angle (e.g., as a function of wavelength) or intensity at one or more wavelengths as a function of scattering angle.

Measurement of targets in dark field metrology may comprise, for example, measuring the a first intensity of the 1^{st} diffraction order I₊₁ and a second intensity of the -1^{st} diffraction order (I₋₁) and calculating an intensity asymmetry (A = I₊₁ - I₋₁), which is indicative of asymmetry in the target. The metrology targets may comprise one or more grating structures from which a parameter of interest may be inferred from such intensity asymmetry measurements, e.g., the targets are designed such that the asymmetry in the target varies with the parameter of interest. For example, in overlay metrology a target may comprise at least one composite grating formed by at least a pair of overlapping sub-gratings that are patterned in different layers of the semiconductor device. Asymmetry of the target will therefore be dependent on alignment of the two layers and therefore overlay. Other targets may be formed with structures which are exposed with different degrees of variation based on the focus setting used during the exposure; the measurement of which enabling that focus setting to be inferred back (again through intensity asymmetry).

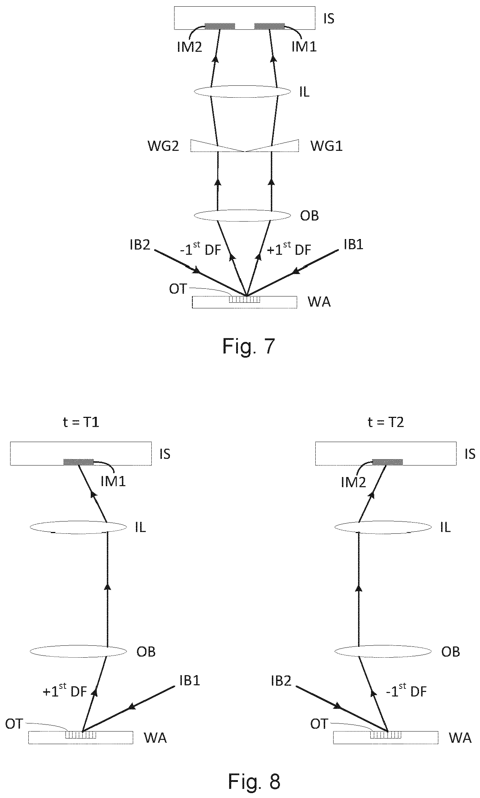

Figure 7 and Figure 8 schematically illustrate two examples of diffraction-based dark field metrology devices. Note that for the sake of simplicity, both figures only show some of the components that are sufficient for the purpose of describing working principle of the two devices.

As illustrated in Figure 7, a first illumination beam of radiation IB1 may be obliquely incident onto an overlay target of a substrate WA from one side of the device. The grating based overlay target may diffract the first illumination beam into a number of diffraction orders. Since the device is configured for dark field imaging, the zeroth diffraction order may be either blocked by an optical component or configure to fall completely outside the numerical aperture of the objective lens OB. At least one non-zeroth diffraction order, e.g., positive first diffraction order +1^{st} DF, may be collected by the objective lens OB. At the pupil plane of the objective lens OB, a first wedge WG1 may be used to re-direct the diffracted radiation to follow a desired beam path. Finally, an imaging lens may be used to focus the diffraction order, e.g., positive first diffraction order +1^{st} DF, onto an image sensor IS such that a first image IM1 is formed at a first location.

Similarly, a second illumination beam of radiation IB2 may be obliquely incident onto the same overlay target OT of the substrate WA from the opposite side of the system. The incident angle of the second illumination beam IB2 may be same as that of the first illumination beam IB1. At least one non-zeroth diffraction order, e.g., negative first diffraction order -1^{st} DF, may be collected by the objective lens OB and subsequently redirected by a second wedge WG2. The negative first diffraction order -1^{st} DF may then be focused by the imaging lens IL onto the image sensor IS such that a second image IM2 is formed at a second location.

The example of Figure 7 is operated in a parallel acquisition scheme. The overlay target is illuminated simultaneously by both illumination beams IB1, IB2. Correspondingly, the two spatially separated images IM1, IM2 of the overlay target are acquired at the same time. Such a parallel acquisition scheme allows for a fast measurement speed and hence high throughput. However, the pupil plane of the objective lens OB has to be shared by the two diffraction orders, e.g., +1^{st} DF and -1^{st} DF. A consequence of dividing the pupil into mutually exclusive illumination and detection pupils is that there is a consequent reduction in the illumination NA and in the detection NA. While there is some flexibility in trade-off between the illumination NA and detection NA, ultimately having both the illumination NA the detection NA as large as is often desirable is not possible within a single pupil. This results in a limited range of angles for each corresponding illumination beam and for the +1^{st} DF and -1^{st} DF beams, which in turn limits the range of allowable grating pitch sizes and/or illumination wavelengths and hence imposes a tight requirement for designing such a metrology system.

Figure 8 schematically illustrates another exemplary dark field metrology device (or different operation mode of the device of Figure 7). The main difference is that the metrology device of Figure 8 is operated in a sequential acquisition scheme. In the sequential acquisition scheme, a metrology target OT is only illuminated by one illumination beam from one direction at any time instance and thereby only one image of the target is formed and acquired at any point in time. Referring to Figure 8, at a first time instance t=T1, a first illumination beam IB1 may be switched on and directed obliquely onto an overlay target OT of a substrate WA from one side of the metrology device. After interaction with the gratings of the overlay target, a number of diffraction orders may be generated. At least one of the non-zeroth diffraction order, e.g., positive first diffraction order +1^{st} DF, may be collected by an objective lens OB and subsequently focused by an imaging lens IL onto an image sensor IS.

Subsequent to the first image IM1 of the overlay gratings being acquired, at a second time instance t=T2, the first illumination beam IB 1 is switched off and a second illumination beam IB2 is switched on. The second illumination beam IB2 may be directly obliquely onto the same overlay target from an opposite side of the metrology device. At least one of the generated diffraction orders, e.g., negative first diffraction order -1^{st} DF, may be collected by the objective lens OB and subsequently focused onto the image sensor IS to form a second image IM2 of the overlay target. Note that both images IM1 and IM2 may be formed at a common position on the image sensor.

With this time multiplexed acquisition scheme, the full NA of the objective lens OB is made available for detecting the diffracted beams +1^{st} DF and -1^{st} DF. No limitation in objective NA means a wider range of relevant design parameters, such as grating pitch sizes, illumination wavelengths and illumination angles, is allowed and a greater flexibility in system design can be obtained. However, the fact that multiple image acquisitions are needed means measurement speed is reduced and hence system throughput is impacted.

In addition, accurate determination of e.g., overlay error, relies on accurate measurement of a minute relative intensity difference (or intensity asymmetry) between the two acquired images IM1, IM2. The typical relative intensity difference is on the order of 10⁻⁴ of the intensity of one of the acquired images, e.g., IM1 or IM2. Such a small intensity difference could easily be dwarfed by any intensity and/or wavelength fluctuations of illumination radiation. Therefore, the illumination beams are required to stay stable during consecutive image acquisitions. This can be achieved by using a stable light source providing desired intensity and wavelength stabilities. Alternatively, additional hardware and software, such as for example intensity/wavelength monitoring device and corresponding feedback control loop, should be incorporated into the metrology device such that intensity and/or wavelength fluctuations of the illumination beams are actively monitored and well compensated. In some cases, an intensity monitoring device may be used to actively track the intensity of the illumination beams. The signal generated from the intensity monitoring device may be used to (e.g., electronically) correct the intensity fluctuations of the illumination beams. All these solutions add complexity and cost to the overall system.

Some or all of aforementioned problems could be addressed by using digital holographic microscopy, in particular dark field digital holographic microscopy. Digital holographic microscopy is an imaging technology that combines holography with microscopy. Different from other microscopy methods that record projected images of an object, digital holographic microscopy records holograms formed by interference between object radiation obtained by irradiation of a three-dimensional (3D) object with object radiation and reference radiation that is coherent with the object radiation. Images may be captured using, for example a charge coupled device (CCD) or a complementary metal oxide semiconductor (CMOS). Since the object radiation is radiation scattered from the object, wave-front of the object radiation is therefore modulated or shaped by the object. Said scattered radiation may comprise reflected radiation, diffracted radiation, or transmitted radiation. Therefore, the wavefront of the object radiation carries information of the irradiated object, e.g., 3D shape information. Based on the captured images of holograms, images of the object can be numerically reconstructed by using a computer reconstruction algorithm. An important advantage of hologram based metrology over intensity based metrology, as described in examples of Figures 7 and 8, is that hologram based metrology allows both intensity and phase information of an object to be obtained. With additional phase information, characteristics of the object can be determined with better accuracy.

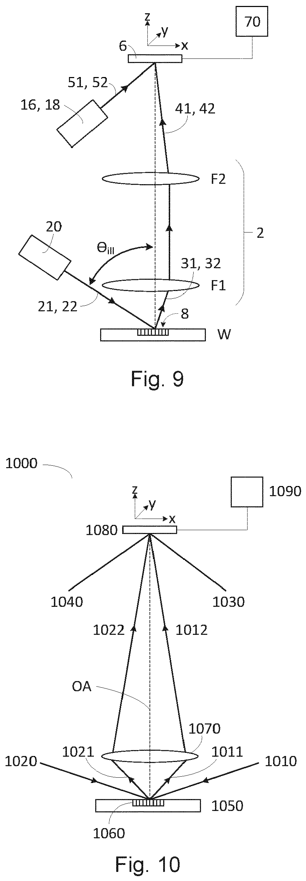

The international patent application WO2019197117A1, incorporated herein by reference, discloses a method and metrology apparatus based on a dark field digital holographic microscope (df-DHM) to determine a characteristic, e.g., overlay, of a structure manufactured on a substrate. For the purpose of description, Figure 3 of the international patent application WO2019197117A1 is replicated in Figure 9. Figure 9 schematically illustrates the disclosed df-DHM specifically adapted for use in lithographic process metrology.

In comparison to the former examples shown in Figures 7 and 8, the df-DHM in Figure 9 further comprises a reference optical unit 16, 18 which is used to provide additional two reference radiation beams 51, 52 (the reference radiation). Such two reference radiation beams 51, 52 are respectively paired with two corresponding portions 41, 42 of the scattered radiation beams 31, 32 (the object radiation). The two scattered-reference beam pairs are used sequentially to form two interference patterns. Coherence control is provided by way of adjusting the relative optical path-length difference (OPD) between the two scattered-reference beams within each beam pair. However, no coherence control is available between the two beam pairs.

Due to the use of a single light source and insufficient coherence control, all four radiation beams, i.e. the first portion 41 of the scattered radiation 31, the first reference radiation 51, the second portion 42 of the scattered radiation 32 and the second reference radiation 52, are mutually coherent. If these four mutually coherent radiation beams were allowed to reach the same position of the sensor 6 at the same time, namely operating in a parallel acquisition scheme, multiple interference patterns comprising desired information containing patterns and undesired artefact-contributing patterns would overlap each other. The undesired interference patterns may be formed by interference between e.g., the portion 41 of the first scattered radiation 31 and the portion 42 of the second scattered radiation 32. Since it would be technically challenging and time consuming to completely separate the superimposed interference patterns, parallel acquisition is impractical this arrangement.

Similar to the example of Figure 8, the use of a sequential acquisition scheme in the example of Figure 9 allows the full NA of the objective lens to be available for both illumination and detection. However, the system suffers the same problem of low measurement speed due to sequential acquisition. Therefore, it is desirable to have a df-DHM capable of performing parallel acquisition such that a high measurement speed and a high design flexibility can be simultaneously obtained.

Figure 10 schematically illustrates the imaging branch of a dark field digital holographic microscope (df-DHM) 1000 in accordance with an embodiment. A dark field digital holographic microscope (df-DHM) comprises an imaging branch and an illumination branch. In this embodiment, a metrology target 1060 comprising a structure on a substrate 1050 is illuminated by two illumination beams of radiation, i.e., a first illumination beam of radiation 1010 and a second illumination beam of radiation 1020. In an embodiment, such two illumination beams 1010, 1020 may simultaneously illuminate the metrology target 1060.

In an embodiment, the first illumination beam 1010 may be incident on the metrology target 1060 at a first angle of incidence in a first direction with respect to the optical axis OA. The second illumination beam 1020 may be incident on the metrology target 1060 at a second angle of incidence in a second direction with respect to the optical axis OA. The first angle of incidence of the first illumination beam 1010 and the second angle of incidence of the second illumination beam 1020 may be substantially the same. The angle of incidence of each illumination beam may be, for example in the range of 70 degrees to 90 degrees, in the range of 50 degrees to 90 degrees, in the range of 30 degrees to 90 degrees, in the range of 10 degrees to 90 degrees. The illumination of the metrology target 1060 may result in radiation being scattered from the target. In an embodiment, the first illumination beam 1010 may be incident on the metrology target 1060 at a first azimuthal angle, corresponding to the first direction. The second illumination beam 1020 may be incident on the metrology target 1060 at a second azimuthal angle, corresponding to the second direction. The first azimuthal angle of the first illumination beam 1010 and the second azimuthal angle of the second illumination beam 1020 may be different; e.g., opposing angles 180 degrees apart.

Depending on the structure of the metrology target 1060, the scattered radiation may comprise reflected radiation, diffracted radiation or transmitted radiation. In this embodiment, the metrology target may be a diffraction-based overlay target; and each illumination beam may correspond to a scattered beam comprising at least one non-zeroth diffraction order. Each scattered beam carries information of the illuminated metrology target. For example, the first illumination beam 1010 may correspond to the first scattered beam 1011 comprising the positive first diffraction order +1^{st} DF; the second illumination beam 1020 may correspond to the second scattered beam 1021 comprising the negative first diffraction order -1^{st} DF. The zeroth diffraction order and other undesired diffraction orders may either be blocked by a beam blocking element (not shown) or configured to completely fall outside the NA of the objective lens 1070. As a result, the df-DHM may be operated in a dark field mode. Note that, in some embodiments, one or more optical elements, e.g., a lens combination, may be used to achieve same optical effect of the objective lens 1070.

Both scattered beams 1011, 1021 may be collected by objective lens 1070 and subsequently re-focused onto an image sensor 1080. Objective lens 1070 may comprise multiple lenses, and/or df-DHM 1000 may comprise a lens system having two or more lenses, e.g., an objective lens and an imaging lens similar to the exemplary df-DHG of Figure 9, thereby defining a pupil plane of the objective lens between the two lenses and an image plane at the focus of the imaging lens. In this embodiment, a portion 1012 of the first scattered beam 1011 and a portion 1022 of the second scattered beam 1021 are simultaneously incident at a common position of the image sensor 1080. At the same time, two reference beams of radiation, i.e. a first reference beam 1030 and a second reference beam 1040, are incident on the same position of the image sensor 1080. Such four beams may be grouped into two pairs of scattered radiation and reference radiation. For example, the first scattered-reference beam pair may comprise the portion 1012 of the first scattered beam 1011 and the first reference beam 1030. Likewise, the portion 1022 of the second scattered-reference beam pair may comprise the second scattered beam 1021 and the second reference beam 1040. These two scattered-reference beam pairs may subsequently form two interference patterns (holographic images) which at least partially overlap in spatial domain.

In an embodiment, in order to separate the two at least partially, spatially overlapping interference patterns (e.g., in the spatial frequency domain), the first reference beam 1030 may have a first angle of incidence with respect to the optical axis OA and the second reference beam 1040 may have a second angle of incidence with respect to the optical axis OA; the first angle of incidence and the second angle of incidence being different. Alternatively or in addition, the first reference beam 1030 may have a first azimuthal angle with respect to the optical axis OA and the second reference beam 1040 may have a second azimuthal angle with respect to the optical axis OA; the first and second azimuthal angles being different.

Metrology tools such as the DHM (or more specifically the df-DHM) have been designed to allow simplification of the objective lens, which allows a significant size and weight reduction of the sensor. WO2021/121733A1 describes a DHM where the main sensor or objective lens assembly is separated from the bulk of the illumination optics, the latter being located in an illuminator box elsewhere in the machine. This enables the sensor to be compact and lightweight.

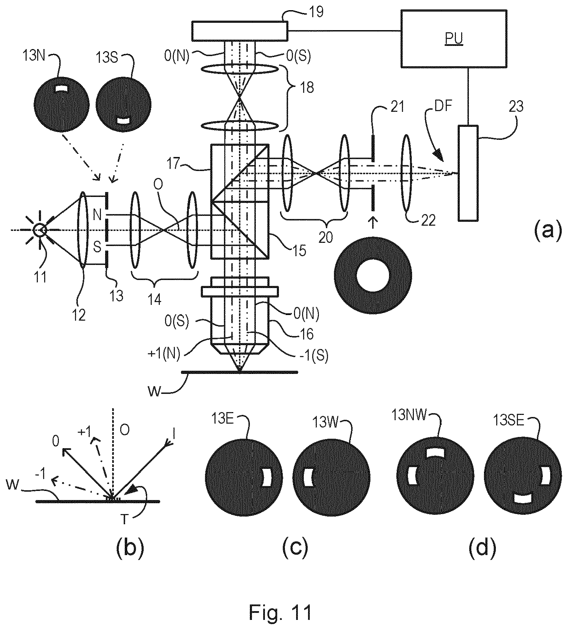

Figure 11(a) presents an embodiment of a metrology apparatus and, more specifically, a dark field scatterometer. A target T and diffracted rays of measurement radiation used to illuminate the target are illustrated in more detail in Figure 11(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 11(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 11(a) and 11(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 11(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A illumination beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 11 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 11) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Simultaneous measurement in opposing directions can be implemented using a suitable aperture plate (e.g., having apertures as a pair of diagonally opposed quadrants) and wedges (to separate the images) in the imaging branch.

The light source used to provide the measurement radiation in metrology tool such as any of those described above may comprise a broadband or supercontinuum radiation source, the output of which may be filtered using a suitable tunable filter such as an acousto-optical tunable filter. In principle, such a configuration may enable a continuous tuning range of more than 2µm, with tuning speeds as low as 1ms. This allows overlay measurements over a wide wavelength range and with fast wavelength switching. The bandwidth of the radiation after the tunable filter may have a bandwidth of approximately 5nm, depending on the central wavelength. This is equivalent to a coherence length of approximately 20 µm. Of course, this is only exemplary and depends on the source and filter parameters which may vary from those described in this example.

When using a DHM, in order to generate an interference pattern, the two beams of each scattered-reference beam pair should be at least partially coherent to each other, to a degree which is sufficient to form an interference pattern. Note that each scattered radiation beam may have a phase offset with respect to its corresponding illumination radiation. For example, at the image plane of the image sensor, such a phase offset may comprise contributions due to the optical path length from the metrology target to the image sensor, and by the interaction with the metrology target. The fringe contrast on the camera, and therefore the measured signal strength, is dependent on the optical path length difference (OPD) between the optical path length of the scattered beam and the optical path length of the reference beam.

A delay line may therefore be included for each scattered-reference beam pair; i.e., each pair of a beam of scattered radiation from the target (scattered beam) and respective reference beam (e.g., referring to Figure 10, the first scattered beam 1011 or the second scattered beam 1021, and its paired reference beam radiation, respectively the first reference beam 1030 or the second reference beam 1040) to match the OPD of the scattered beam to that of the reference beam, such that the OPD is well within the coherence length of the radiation.

WO2021/121733A1 describes such an arrangement, which has the further functionality of controlling coherence between the first scattered-reference beam pair and the second scattered-reference beam pair such that each beam of one pair is incoherent to any beam of the other pair. In other words, the OPDs can be controlled such that interference only occurs between the beams within the same beam pair and suppressed between different beam pairs. In such a manner, only desired interference patterns, e.g., the two interference patterns formed by respect scattered-reference beam pairs, are formed in a superimposed manner on the image sensor, thus obviating the problem of separating or removing undesired interference patterns.

The use of a delay line to control the OPD in each scattered-reference beam pair works well for targets that are thin compared to the coherence length of the measurement radiation. However, for thicker stacks, such as 3D-NAND stacks, the top and bottom gratings (or more generally, periodic structures) are widely separated, e.g., by a difference comparable to greater than the radiation coherence length. This prevents the radiation diffracted from the top grating from interfering with radiation that is diffracted by the bottom grating.

To address this, it is proposed to create at least one illumination beam or reference beam, wherein each said illumination beam or reference beam comprises a combination of a first beam component having a first optical path length and a second beam component having a second optical path length. At least one of the first and second optical path lengths is variable such that when used to measure an overlay target, there is interference at the detector between the reference beam and diffracted light from the bottom grating and from the top grating.

To achieve this, it is proposed to split the illumination beam or reference beam into the first and second beam components, vary the optical path length of one or both of the beam components, so as delay one component with respect to the other component and then combine the components again to form a modified radiation beam.

In the example given below, it will be assumed that it is the illumination beam (or object beam) which is modified to obtain the modified radiation beam, however it should be appreciated that the principle can be implemented equally by modifying the reference beam. What is important is that the optical path length of a portion of the illumination beam which is diffracted by a top grating and the optical path length of a portion of the illumination beam which is diffracted by a bottom grating are each able to be maintained within the coherence length of the optical path length of the reference beam.

A radiation beam modifier module, or one such module per illumination beam, may be provided in the illumination optics (e.g., the illuminator box) to implement this. The or each radiation beam modifier module may be operable to receive source illumination and output a modified radiation beam comprising a first beam component and a second beam component, each said at least one radiation beam modifier module comprising at least one path length varying arrangement for controllably varying the optical path length of at least one of said first beam component and said second beam component, such that said first beam component and second beam component of said modified radiation beam comprise a respective different optical path length.

In an embodiment, the or each radiation beam modifier module may comprise a beam splitter, the at least one path length varying arrangement for controllably varying the path length of one of the beam components, and optionally a path length varying arrangement for each component, and a beam combiner. In an alternative arrangement, or each radiation beam modifier module may comprise a Fabry-Perot cavity.

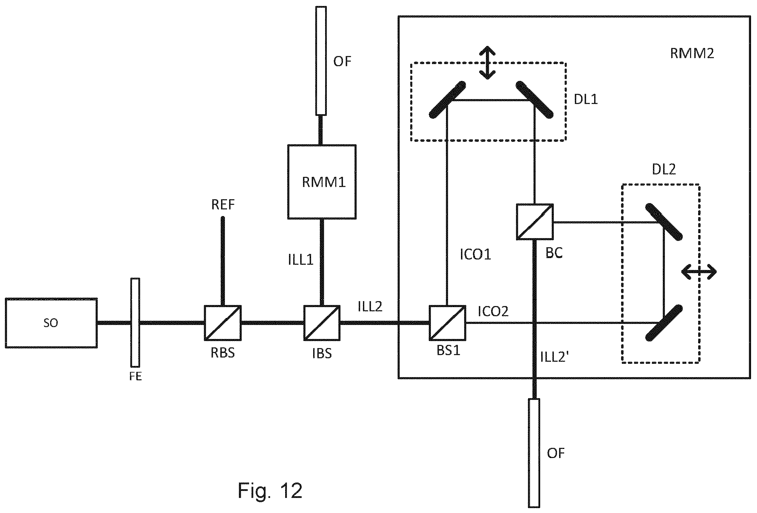

Figure 12 is a schematic illustration of an illumination arrangement according to an embodiment, for providing illumination for use in a DHM or other holographic metrology tool. A broadband or supercontinuum source SO provides illumination. In this DHM embodiment, the illumination source may comprise a spatially coherent source. The output of the illumination source SO may be filtered by a tunable spectral filtering element FE, such as (for example) an acousto-optical tunable filter. In other embodiments, the illumination spectral characteristics may be adjustable within the illumination source SO itself. A reference beam splitter RBS splits off a reference beam REF from the filtered source output. A further beam splitter (not shown) may split this reference beam REF into a pair of reference beams (e.g., to provide reference beams for simultaneous measurement in two directions as has been described in relation to Figure 10), or another beam splitter (not shown) may be provided in this source output path to provide the second reference beam. The reference beams can then be inputted directly into a respective optical fiber (not shown) and into a DHM. An illumination beam splitter IBS splits the remaining source illumination into a first illumination beam ILL1 and a second illumination beam ILL2. Each of these illumination beams ILL1, ILL2 is inputted to a respective radiation beam modifier module RMM1, RMM2.

Only one of the radiation beam modifier modules RMM2 is shown in schematic detail. The illumination beam ILL2 is split by first beam splitter BS1 into first illumination beam component ICO1 and second illumination beam component ICO2. A path length varying arrangement, such as a variable optical delay line DL1, DL2 is provided in the path of each (or at least one) illumination beam component ICO1, ICO2. The delayed beam components are recombined by beam combiner BC into modified illumination beam ILL2' comprising the two beam components having different optical path lengths. As such, the modified illumination beam ILL2' will have two optical path lengths, one per component. The path length difference may be tuned to the difference in optical path lengths caused by the distance between gratings. The modified illumination beam ILL2' can then be coupled into an optical fiber OF (or other beam delivery arrangement) for use in a DHM.

Using such an radiation beam modifier module, it is possible to adjust delay line DL1 such that the optical path length of the first illumination beam component ICO1, which diffracts off a top grating of an overlay target, matches the optical path length of the reference beam, while adjust delay line DL2 can be adjusted such that the optical path length of the second illumination beam component ICO2, which diffracts off the bottom grating of the overlay target, also matches the optical path length of the reference beam. As a result of this, radiation from the top and bottom grating can interfere despite the short coherence length making it possible to obtain a valid overlay measurement from a thick target. For example, using an example where only one delay line is varied, the distance D that the delay line should be moved (i.e., along the double-headed arrow in Figure 12) may be D=nΔL/2, where nΔL is the OPD, n is the effective refractive index of the target (there may be many different materials between the two gratings, for example) and ΔL is the geometric path length difference caused by the distance between gratings. Throughout this disclosure, any reference to matching of optical path lengths refers to matching to within the coherence length of the radiation.

The arrangement may of course vary from the embodiment shown. For example, it may be that only one of the beam components has a variable delay; e.g., when the delay between the illumination beam and reference beam is separately adjustable, such as described in WO2021/121733A1. For example, this latter adjustment can adjust path length of one component for one grating to match that of the reference beam, and the delay line used to adjust the other beam component for the other grating. The delay lines shown are only one example of a path length varying arrangement, and any suitable path length varying arrangement may be employed. Furthermore, first beam splitter BS1 and beam combiner BC may be separate elements as depicted, or a single element which provides both functions.

As already stated, the radiation beam modifier module(s) may be located to modify the reference beam(s) rather than the illumination or object beam(s).

The depicted example shows an embodiment for a DHM or holography metrology tool which uses two reference beams and illumination beams, e.g., for two simultaneous measurements in opposite directions. However, of course, the arrangement may comprise only a single radiation beam modifier module to modify only a single illumination beam (i.e., illumination beam splitter IBS would not be required), and additionally only provide a single reference beam; e.g., to provide radiation for a holography metrology tool which performs single sequential measurements only.

The concepts herein are not limited to holography metrology tools, and may be used in other types of metrology tools; e.g., so that they may be used to measure thick stacks. For example, the concepts herein may be used in a scatterometer based metrology tool, for example such as illustrated in Figure 11(a). Of course, the illumination arrangement for such a tool would not need to split off any reference illumination beams, and therefore may be used to generate only one or more modified illumination beams, each having two optical path lengths, from the illumination source.

Such scatterometer based tools may use spatially incoherent radiation as has been described, or otherwise. For example, the tool illustrated in Figure 11(a) presently uses quasi-monochromatic light that is spatially incoherent. Such radiation has a coherence length which can be shorter than the coherence length of the spatially coherent radiation typically used in a DHM. Therefore the concepts disclosed herein may be used for such scatterometer based tools which use temporally coherent radiation.

It should be appreciated that the concepts described may have the disadvantage of radiation loss at the beam splitters. When measuring thick stacks, delay lines DL1 and DL2 may be mismatched to well outside the coherence length of the radiation such that the two beam components add incoherently at the beam combiner BC. In this case, at least half of the radiation will be lost to the beam combiner's other output. However, such thick targets cannot presently be measured at all using conventional techniques, without using an illumination beam modifier as disclosed herein. As such, the concepts disclosed herein represent the difference between obtaining a valid signal and no signal at all when measuring thick targets with radiation having a coherence length smaller than the inter-grating distance. In an optional embodiment, another metrology device may use the radiation output of the beam combiner's BC other output face.

The illumination arrangement may contain other optical elements, e.g., optical attenuators to better match the signals collected from the top and bottom gratings.

The illumination arrangement may be configurable for measurement of thin targets, e.g., smaller than the coherence length of the illumination; i.e., to output one or more conventional illumination beams. This can be achieved in a number of ways. Firstly, the radiation beam modifier module(s) may be configured to be physically switched out of the illumination beam path between the illumination source and optical fiber, e.g., by switching out each modules' beam splitter. Alternatively, the delay line(s) may be arranged such that the path lengths of the two beam components are matched to within the coherence length of the radiation, such that the light coherently interferes at the beam combiner. In this case the fraction of the light output to the sensor can be made to be 100% by carefully adjusting the phase difference between the components. Such tuning can be made using a piezo-electric stage, for example.

In another embodiment, the or each radiation beam modifier module may comprise a Fabry-Perot cavity rather than the beam splitter, delay line and beam combiner arrangement shown. In a Fabry-Perot cavity, defined by two partial reflectors, radiation is reflected back and forth within the cavity. After each reflection, a portion or component of the radiation escapes from the cavity resulting in a pulse-train. The first and second beam components described herein correspond with the first two of these pulses. Each pulse is successively weaker; this decay can be tuned by appropriately selecting the reflection at each end of the cavity, resulting in a trade-off between power and equality of pulse intensities.

The tuning of the Fabry-Perot cavity (i.e., its path length varying arrangement) is implemented by varying its length L, i.e., the distance between the two reflectors, where L=OPD/n_{cav}= nΔL/n_{cav.}. n is the effective refractive index of the target ("effective" refractive index as there may be many different materials between the two gratings, for example), ΔL is the geometric path length difference caused by the distance between gratings and n_{cav} is the refractive index of the cavity.

The advantage of using a Fabry-Perot cavity is that it is simpler and easier to switch in and out of the optical path. However, the Fabry-Perot cavity results in lower modified beam power output (greater losses) than the arrangement illustrated in Figure 12, and unbalanced pulse/component powers (the pulse outputs can be made more balanced at a cost of further overall power loss).

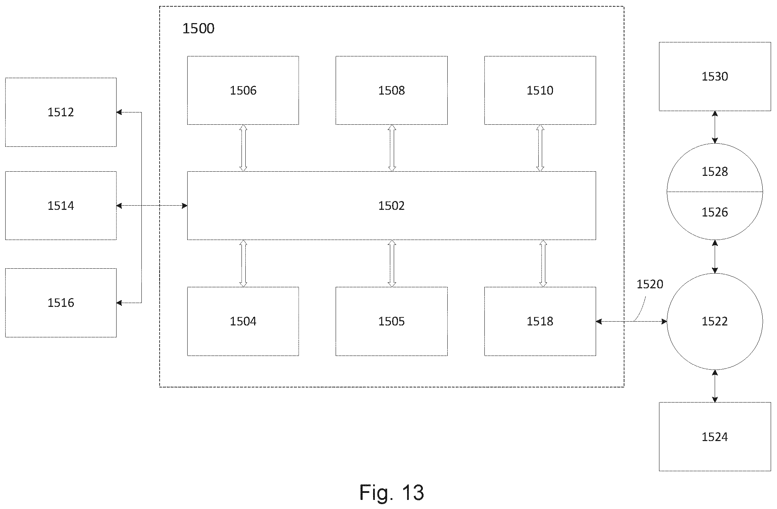

Figure 13 is a block diagram that illustrates a computer system 1500 that may assist in implementing the methods and flows disclosed herein. Computer system 1500 includes a bus 1502 or other communication mechanism for communicating information, and a processor 1504 (or multiple processors 1504 and 1505) coupled with bus 1502 for processing information. Computer system 1500 also includes a main memory 1506, such as a random access memory (RAM) or other dynamic storage device, coupled to bus 1502 for storing information and instructions to be executed by processor 1504. Main memory 1506 also may be used for storing temporary variables or other intermediate information during execution of instructions to be executed by processor 1504. Computer system 1500 further includes a read only memory (ROM) 1508 or other static storage device coupled to bus 1502 for storing static information and instructions for processor 1504. A storage device 1510, such as a magnetic disk or optical disk, is provided and coupled to bus 1502 for storing information and instructions.

Computer system 1500 may be coupled via bus 1502 to a display 1512, such as a cathode ray tube (CRT) or flat panel or touch panel display for displaying information to a computer user. An input device 1514, including alphanumeric and other keys, is coupled to bus 1502 for communicating information and command selections to processor 1504. Another type of user input device is cursor control 1516, such as a mouse, a trackball, or cursor direction keys for communicating direction information and command selections to processor 1504 and for controlling cursor movement on display 1512. This input device typically has two degrees of freedom in two axes, a first axis (e.g., x) and a second axis (e.g., y), that allows the device to specify positions in a plane. A touch panel (screen) display may also be used as an input device.

One or more of the methods as described herein may be performed by computer system 1500 in response to processor 1504 executing one or more sequences of one or more instructions contained in main memory 1506. Such instructions may be read into main memory 1506 from another computer-readable medium, such as storage device 1510. Execution of the sequences of instructions contained in main memory 1506 causes processor 1504 to perform the process steps described herein. One or more processors in a multi-processing arrangement may also be employed to execute the sequences of instructions contained in main memory 1506. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 1504 for execution. Such a medium may take many forms, including but not limited to, non-volatile media, volatile media, and transmission media. Non-volatile media include, for example, optical or magnetic disks, such as storage device 1510. Volatile media include dynamic memory, such as main memory 1506. Transmission media include coaxial cables, copper wire and fiber optics, including the wires that comprise bus 1502. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 1504 for execution. For example, the instructions may initially be borne on a magnetic disk of a remote computer. The remote computer can load the instructions into its dynamic memory and send the instructions over a telephone line using a modem. A modem local to computer system 1500 can receive the data on the telephone line and use an infrared transmitter to convert the data to an infrared signal. An infrared detector coupled to bus 1502 can receive the data carried in the infrared signal and place the data on bus 1502. Bus 1502 carries the data to main memory 1506, from which processor 1504 retrieves and executes the instructions. The instructions received by main memory 1506 may optionally be stored on storage device 1510 either before or after execution by processor 1504.

Computer system 1500 also preferably includes a communication interface 1518 coupled to bus 1502. Communication interface 1518 provides a two-way data communication coupling to a network link 1520 that is connected to a local network 1522. For example, communication interface 1518 may be an integrated services digital network (ISDN) card or a modem to provide a data communication connection to a corresponding type of telephone line. As another example, communication interface 1518 may be a local area network (LAN) card to provide a data communication connection to a compatible LAN. Wireless links may also be implemented. In any such implementation, communication interface 1518 sends and receives electrical, electromagnetic or optical signals that carry digital data streams representing various types of information.

Network link 1520 typically provides data communication through one or more networks to other data devices. For example, network link 1520 may provide a connection through local network 1522 to a host computer 1524 or to data equipment operated by an Internet Service Provider (ISP) 1526. ISP 1526 in turn provides data communication services through the worldwide packet data communication network, now commonly referred to as the "Internet" 1528. Local network 1522 and Internet 1528 both use electrical, electromagnetic or optical signals that carry digital data streams. The signals through the various networks and the signals on network link 1520 and through communication interface 1518, which carry the digital data to and from computer system 1500, are exemplary forms of carrier waves transporting the information.

Computer system 1500 may send messages and receive data, including program code, through the network(s), network link 1520, and communication interface 1518. In the Internet example, a server 1530 might transmit a requested code for an application program through Internet 1528, ISP 1526, local network 1522 and communication interface 1518. One such downloaded application may provide for one or more of the techniques described herein, for example. The received code may be executed by processor 1504 as it is received, and/or stored in storage device 1510, or other non-volatile storage for later execution. In this manner, computer system 1500 may obtain application code in the form of a carrier wave.

Further embodiments are disclosed in the subsequent list of numbered clauses:
1. An illumination arrangement for providing at least one radiation beam for use as an illumination beam and/or reference beam in a metrology device, the illumination arrangement comprising:
   at least one radiation beam modifier module operable to receive source illumination and output a modified radiation beam comprising a first beam component and a second beam component, each said at least one radiation beam modifier module comprising:
   at least one path length varying arrangement for controllably varying the optical path length of at least one of said first beam component and said second beam component, such that said first beam component and second beam component of said modified radiation beam comprise a respective different optical path length.
2. A method as defined in clause 1, wherein each said at least one radiation beam modifier module comprises:
   a first beam splitter operable to split source illumination into said first beam component and said second beam component; and
   a beam combiner for recombining said first beam component and a second beam component, subsequent to said at least one path length varying arrangement, into said modified radiation beam.
3. An illumination arrangement as defined in clause 2, wherein said at least one path length varying arrangement comprises a respective path length varying arrangement for each of said first beam component and a second beam component.
4. An illumination arrangement as defined in clause 2 or 3, wherein each of said at least one path length varying arrangement comprises an adjustable optical delay line.
5. An illumination arrangement as defined in clause 2, 3 or 4, wherein said first beam splitter and said beam combiner are physically separate elements.
6. An illumination arrangement as defined in clause 2, 3 or 4, wherein said first beam splitter and said beam combiner are comprised as a single element.
7. An illumination arrangement as defined in clause 6, wherein each said at least one radiation beam modifier module comprises a Fabry-Perot cavity.
8. An illumination arrangement as defined in any preceding clause, comprising:
   an illumination beam or reference beam splitter for splitting said source radiation into two illumination beams or reference beams; and
   a respective radiation beam modifier module for each of said two illumination beams or reference beams, to provide two of said modified radiation beams.
9. An illumination arrangement as defined in any preceding clause, wherein said illumination arrangement is operable to vary said at least one path length varying arrangement so as to configure an optical path length difference between said first beam component and said second beam component to compensate for a distance between a first periodic structure and second periodic structure of an overlay target being greater than a coherence length of said source illumination, each at least one modified radiation beam being used in the measurement of said overlay target.
10. An illumination arrangement as defined in clause 9, comprising at least one reference beam splitter to obtain at least one reference beam.
11. An illumination arrangement as defined in clause 10, wherein the or each said modified radiation beam is configured to be an illumination beam for illuminating a structure to be measured by said metrology device.
12. An illumination arrangement as defined in clause 11, wherein said illumination arrangement is operable to vary said at least one path length varying arrangement such that said first beam component, following scattering by said first periodic structure, has an optical path length matched to within said coherence length to an optical path length of said reference beam and said second beam component, following scattering by said second periodic structure, has an optical path length matched to within said coherence length to the optical path length of said reference beam.
13. An illumination arrangement as defined in clause 10, wherein the or each said modified radiation beam is configured to be each said at least one reference beam.
14. An illumination arrangement as defined in clause 13, wherein said illumination arrangement is operable to vary said at least one path length varying arrangement such that said first beam component has an optical path length matched to within said coherence length to an optical path length of a portion of an illumination beam scattered by said first periodic structure and said second beam component has an optical path length matched to within said coherence length to the optical path length a portion of an illumination beam scattered by said second periodic structure.
15. An illumination arrangement as defined in any preceding clause, wherein at least said first beam splitter is configurable to be switched in and out of the path of said source illumination.
16. An illumination arrangement as defined in any preceding clause, comprising an illumination source operable to provide said source illumination.
17. An illumination arrangement as defined in clause 16, wherein said illumination source is configured to provide broadband source radiation.
18. An illumination arrangement as defined in clause 17, comprising a tunable spectral filter to spectrally filter said broadband source radiation.
19. An illumination arrangement as defined in clause 16, 17 or 18, wherein said illumination source is configured to provide spatially coherent or spatially incoherent source radiation.
20a. A metrology apparatus for determining a characteristic of interest of a structure on a substrate comprising the illumination arrangement of any preceding clause and configured to use said at least one modified radiation beam as measurement illumination or reference illumination to measure said structure.
20b. A metrology apparatus as defined in clause 20, comprising a digital holographic microscope or a scatterometry based metrology device.
21. A method for providing at least one illumination beam or reference beam for a metrology device, the method comprising:
   receiving source illumination and generating a modified radiation beam comprising a first beam component and a second beam component; and
   controllably varying the optical path length of at least one of said first beam component and said second beam component, such that said first beam component and second beam component of said modified radiation beam comprise a respective different optical path length.
22. A method as defined in clause 21, comprising splitting the source illumination into a first beam component and a second beam component;
   performing said controllably varying the optical path length of at least one of said first beam component and said second beam component; and
   recombining said first beam component and a second beam component into the modified radiation beam.
23. A method as defined in clause 22, comprising controllably varying the optical path length of each of said first beam component and said second beam component.
24. A method as defined in clause 21, wherein said controllably varying the optical path length step comprises controllably varying the distance between reflectors of a Fabry-Perot cavity which receives said source radiation and outputs said modified radiation beam.
25. A method as defined in any of clauses 21 to 24, comprising performing said method on each of two illumination beams to obtain two of said modified radiation beams; and
   using each of said two modified radiation beams to perform simultaneous measurements from two different directions.
26. A method as defined in any of clauses 21 to 25, comprising using the at least one modified radiation beam in measuring an overlay target, the overlay target having a first periodic structure and second periodic structure separated by a distance greater than a coherence length of said source illumination; and
   performing said controllably varying step to configure an optical path length difference between said first beam component and said second beam component to compensate for said distance between the first periodic structure and second periodic structure.
27. A method as defined in clause 26, wherein said measuring comprises performing a holographic measurement, wherein the or each said modified radiation beam is configured to be an illumination beam for illuminating a structure to be measured by said metrology device; the method further comprising
   performing said controllably varying step such that said first beam component, following scattering by said first periodic structure, has an optical path length matched to within said coherence length to an optical path length of a reference beam and said second beam component, following scattering by said second periodic structure, has an optical path length matched to within said coherence length to the optical path length of said reference beam.
28. A method as defined in clause 26, wherein said measuring comprises performing a holographic measurement, wherein the or each said modified radiation beam is configured to be a reference beam; and
   performing said controllably varying step such that said first beam component has an optical path length matched to within said coherence length to an optical path length of a portion of an illumination beam scattered by said first periodic structure and said second beam component has an optical path length matched to within said coherence length to the optical path length a portion of an illumination beam scattered by said second periodic structure.
29. A method as defined in any of clauses 21 to 28, wherein said source illumination comprises broadband source radiation.
30. A method as defined in clause 29, comprising spectrally filtering said broadband source radiation.
31. A method as defined in any of clauses 21 to 30, wherein said source illumination comprises spatially coherent or spatially incoherent source radiation.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. An illumination arrangement for providing at least one radiation beam for use as an illumination beam and/or reference beam in a metrology device, the illumination arrangement comprising:
at least one radiation beam modifier module operable to receive source illumination and output a modified radiation beam comprising a first beam component and a second beam component, each said at least one radiation beam modifier module comprising:
at least one path length varying arrangement for controllably varying the optical path length of at least one of said first beam component and said second beam component, such that said first beam component and second beam component of said modified radiation beam comprise a respective different optical path length.

2. A method as claimed in claim 1, wherein each said at least one radiation beam modifier module comprises:
a first beam splitter operable to split source illumination into said first beam component and said second beam component; and
a beam combiner for recombining said first beam component and a second beam component, subsequent to said at least one path length varying arrangement, into said modified radiation beam.

3. An illumination arrangement as claimed in claim 2, wherein said at least one path length varying arrangement comprises a respective path length varying arrangement for each of said first beam component and a second beam component.

4. An illumination arrangement as claimed in claim 2 or 3, wherein each of said at least one path length varying arrangement comprises an adjustable optical delay line.

5. An illumination arrangement as claimed in claim 2, 3 or 4, wherein said first beam splitter and said beam combiner are physically separate elements.

6. An illumination arrangement as claimed in claim 2, 3 or 4, wherein said first beam splitter and said beam combiner are comprised as a single element.

7. An illumination arrangement as claimed in any preceding claim, comprising:
an illumination beam or reference beam splitter for splitting said source radiation into two illumination beams or reference beams; and
a respective radiation beam modifier module for each of said two illumination beams or reference beams, to provide two of said modified radiation beams.

8. An illumination arrangement as claimed in any preceding claim, wherein said illumination arrangement is operable to vary said at least one path length varying arrangement so as to configure an optical path length difference between said first beam component and said second beam component to compensate for a distance between a first periodic structure and second periodic structure of an overlay target being greater than a coherence length of said source illumination, each at least one modified radiation beam being used in the measurement of said overlay target.

9. An illumination arrangement as claimed in claim 8, comprising at least one reference beam splitter to obtain at least one reference beam.

10. An illumination arrangement as claimed in claim 9, wherein the or each said modified radiation beam is configured to be an illumination beam for illuminating a structure to be measured by said metrology device, or wherein the or each said modified radiation beam is configured to be each said at least one reference beam.

11. An illumination arrangement as claimed in any preceding claim, wherein at least said first beam splitter is configurable to be switched in and out of the path of said source illumination.

12. An illumination arrangement as claimed in any preceding claim, comprising an illumination source operable to provide said source illumination.

13. A metrology apparatus for determining a characteristic of interest of a structure on a substrate comprising the illumination arrangement of any preceding claim and configured to use said at least one modified radiation beam as measurement illumination or reference illumination to measure said structure.

14. A metrology apparatus as claimed in claim 13, comprising a digital holographic microscope or a scatterometry based metrology device.

15. A method for providing at least one illumination beam or reference beam for a metrology device, the method comprising:
receiving source illumination and generating a modified radiation beam comprising a first beam component and a second beam component; and
controllably varying the optical path length of at least one of said first beam component and said second beam component, such that said first beam component and second beam component of said modified radiation beam comprise a respective different optical path length.
